# EUROPEAN PATENT APPLICATION

(11) **EP 4 571 110 A1**
(43) Date of publication of application: **18.06.2025**
(21) Application number: 24215398.9
(22) Date of filing: 26.11.2024
(51) Int. Cl.: F04B 37/08, F04B 37/14

(54) **CRYOPUMP**

(30) Priority: 12.12.2023 JP 2023209662
(71) Applicant: Sumitomo Heavy Industries, Ltd., Tokyo 141-6025 (JP)
(72) Inventor: TAMADA, Jun, Tokyo 188-8585 (JP)
(74) Representative: Louis Pöhlau Lohrentz

(57) **Abstract**

Provided is a cryopump (10) that enables both improvement in productivity of vacuum process equipment through shortening of a recovery time and compatibility with an existing vacuum process in the vacuum process equipment. A cryopump (10) includes a radiation shield (30), an intake port plate (32), and a skirt (33) that are thermally coupled to a first cooling stage (22) of a cryocooler (14), and a cryopanel unit (20) that is thermally coupled to a second cooling stage (24) of the cryocooler (14) and disposed inside the radiation shield (30). The skirt (33) extends from an outer periphery of the intake port plate (32) into the radiation shield (30). A gas inlet (46) is formed between the intake port plate (32) and the radiation shield (30), and a frost accommodation space (38) is formed between the cryopanel unit (20) and the intake port plate (32). A gas flow path (48) that connects the gas inlet (46) to the frost accommodation space (38) is formed between the skirt (33) and the radiation shield (30).

## Description

### BACKGROUND OF THE INVENTION

### Field of the Invention

The present invention relates to a cryopump.

### Description of Related Art

A cryopump is a vacuum pump that captures gas molecules on a cryopanel cooled to a cryogenic temperature by condensation or adsorption to exhaust the gas molecules. The cryopump is generally used to realize a clean vacuum environment which is required for a semiconductor circuit manufacturing process or the like (for example, PCT Japanese Translation Patent Publication No. 2017-515046).

### SUMMARY OF THE INVENTION

As an example of an application of the cryopump, there is vacuum process equipment that executes a predetermined process on a workpiece such as a semiconductor wafer, for example, in a vacuum environment in a vacuum chamber, such as a vacuum film-forming apparatus such as a sputtering apparatus, for example. During such a vacuum process, a gas required for the process is supplied to the vacuum chamber of the equipment. The vacuum chamber can be kept at the degree of vacuum suitable for the vacuum process by a balance between the supply of the process gas to the vacuum chamber and the evacuation of the vacuum chamber via a cryopump. The supply of the process gas is stopped during an interval between the process and the process, and the degree of vacuum of the vacuum chamber is recovered by the cryopump to a desired degree of vacuum higher than that during the process. A time required for the recovery of the degree of vacuum is also referred to as a recovery time (or a return time). The shorter the recovery time, the earlier the next process can be started, and the productivity of the vacuum process equipment is improved. Therefore, it is desirable that the recovery time is as short as possible.

In order to shorten the recovery time, the pumping speed of the cryopump may be increased. As one means for that, it is generally recognized to increase an opening ratio of a cryopump intake port, that is, the ratio of an opening area to the total area of the intake port. An increase in the opening ratio of the cryopump intake port increases the pumping speed of the cryopump not only during the interval between the processes but also during the process. Therefore, the increase in the opening ratio can lower the vacuum chamber pressure during the process. In some cases, the vacuum chamber pressure may deviate from a desired default pressure for the process. Such an unintended change in the process recipe may have an unexpected influence on the quality of the process. For example, in the vacuum film-formation, the pressure during the process affects a film thickness that is generated. In other words, it is concerned that an increase in the opening ratio of the cryopump intake port may bring about a disadvantage of inconsistency with an existing vacuum process, while leading to an advantage of shortening the recovery time and improving the productivity of the vacuum process equipment due to the shortening of the recovery time.

One of exemplary objects of an aspect of the present invention is to provide a cryopump that makes it possible to improve productivity of vacuum process equipment through shortening of a recovery time and to achieve compatibility with an existing vacuum process in the vacuum process equipment.

According to an aspect of the present invention, there is provided a cryopump including: a cryopump container that defines a cryopump intake port; a cryocooler that is installed in the cryopump container and includes a first cooling stage and a second cooling stage that is cooled to a lower temperature than the first cooling stage; a radiation shield that is thermally coupled to the first cooling stage and extends in an axial direction from the cryopump intake port into the cryopump container; an intake port plate that is thermally coupled to the first cooling stage and extends along a plane perpendicular to the axial direction in the cryopump intake port, and in which a gas inlet is formed between the intake port plate and the radiation shield; a cryopanel unit that is thermally coupled to the second cooling stage and is disposed inside the radiation shield, and in which a frost accommodation space is formed between the cryopanel unit and the intake port plate; and a skirt that is thermally coupled to the first cooling stage and extends from an outer periphery of the intake port plate into the radiation shield, and in which a gas flow path connecting the gas inlet to the frost accommodation space is formed between the skirt and the radiation shield.

According to the present invention, it is possible to provide a cryopump that makes it possible to improve productivity of vacuum process equipment through shortening of a recovery time and to achieve compatibility with an existing vacuum process in the vacuum process equipment.

### BRIEF DESCRIPTION OF THE DRAWINGS

Fig. 1 is a side sectional view schematically showing a cryopump according to an embodiment.
Fig. 2 is a top view schematically showing a first-stage cryopanel of the cryopump according to the embodiment.
Fig. 3 is a schematic diagram showing the cryopump during an operation according to the embodiment.
Fig. 4 is a diagram schematically showing an exemplary pressure change during the operation of vacuum process equipment equipped with the cryopump according to the embodiment.
Figs. 5A and 5B are schematic diagrams showing first-stage cryopanels of cryopumps according to comparative examples.
Fig. 6 is a schematic diagram showing the pumping speeds of the cryopumps according to the comparative examples of Figs. 5A and 5B.
Fig. 7 is a schematic diagram showing the pumping speed of the cryopump according to the embodiment.

### DETAILED DESCRIPTION OF THE INVENTION

Hereinafter, embodiments for carrying out the present invention will be described in detail with reference to the drawings. In the description and drawings, identical or equivalent components, members, and processing are denoted by the same reference numerals, and overlapping description is omitted as appropriate. The scale or shape of each part that is shown in the drawings is conveniently set for ease of description and is not limitedly interpreted unless otherwise specified. The embodiments are exemplary and do not limit the scope of the present invention in any way. All features or combinations thereof described in the embodiments are not essential to the invention.

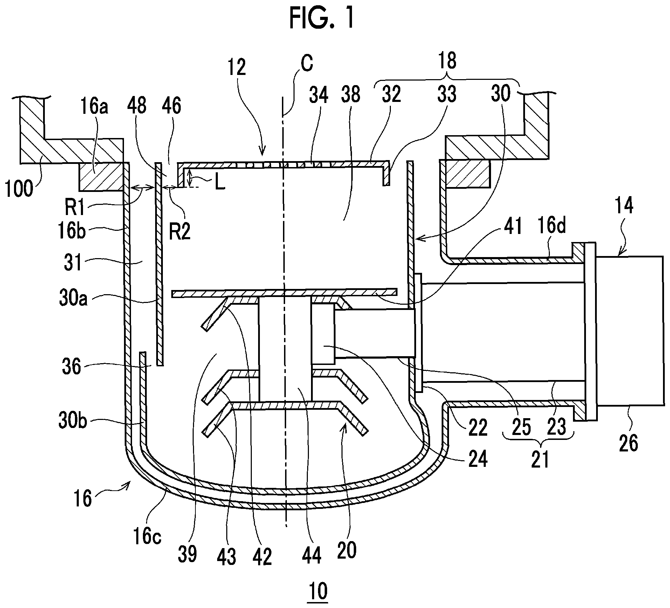

Fig. 1 is a side sectional view schematically showing a cryopump 10 according to an embodiment. In Fig. 1, a cross section including a cryopump center axis (hereinafter, simply referred to as a center axis) C is shown. For easy understanding, the center axis C is shown by a dash-dot line in Fig. 1.

The cryopump 10 is mounted on a vacuum chamber 100 of, for example, an ion implanter, a sputtering apparatus, a vapor deposition apparatus, or other vacuum process equipment, and is used to increase the degree of vacuum in the interior of the vacuum chamber 100 to a level that is required for a desired vacuum process. The cryopump 10 includes a cryopump intake port 12 for receiving a gas to be exhausted from the vacuum chamber 100. The gas enters the internal space of the cryopump 10 through the cryopump intake port 12.

In the following, there is a case where the terms "axial direction" and "radial direction" are used in order to express the positional relationship between components of the cryopump 10 in an easily understandable manner. The axial direction of the cryopump 10 represents a direction passing through the cryopump intake port 12 (that is, a direction along the center axis C in the drawings), and the radial direction represents a direction along the cryopump intake port 12 (a direction perpendicular to the center axis C). For convenience, with respect to the axial direction, there is a case where the side relatively close to the cryopump intake port 12 is referred to as an "upper side" and the side relatively distant from the cryopump intake port 12 is referred to as a "lower side". That is, there is a case where the side relatively distant from a bottom portion of the cryopump 10 is referred to as an "upper side" and the side relatively close to the bottom portion of the cryopump 10 is referred to as a "lower side". With respect to the radial direction, there is a case where the side close to the center (the center axis C in the drawings) of the cryopump intake port 12 is referred to as an "inner side", and the side close to the peripheral edge of the cryopump intake port 12 is referred to as an "outer side". Such expressions are not related to the disposition when the cryopump 10 is mounted on the vacuum chamber 100. For example, the cryopump 10 may be mounted on the vacuum chamber 100 with the cryopump intake port 12 facing downward in the vertical direction.

In addition, there is a case where a direction surrounding the center axis C is referred to as a "circumferential direction". The circumferential direction is a second direction along the circumference of the cryopump intake port 12 and is a tangential direction orthogonal to the radial direction.

The cryopump 10 includes a cryocooler 14, a cryopump container 16, a first-stage cryopanel 18, and a cryopanel unit 20. The first-stage cryopanel 18 may be referred to as a high-temperature cryopanel part or a 100 K part. The cryopanel unit 20 is a cryopanel of a second stage and may be referred to as a low-temperature cryopanel part or a 10 K part.

The cryocooler 14 is a cryocooler such as a Gifford McMahon type cryocooler (a so-called GM cryocooler), for example. The cryocooler 14 is a two-stage cryocooler, and includes a first cooling stage 22 and a second cooling stage 24. The cryocooler 14 is configured to cool the first cooling stage 22 to a first cooling temperature and cool the second cooling stage 24 to a second cooling temperature. The second cooling temperature is lower than the first cooling temperature. For example, the first cooling stage 22 is cooled to a temperature in a range of about 65 K to 120 K, preferably, in a range of 80 K to 100 K, and the second cooling stage 24 is cooled to a temperature in a range of about 10 K to 20 K. The first cooling stage 22 and the second cooling stage 24 may be referred to as a high-temperature cooling stage and a low-temperature cooling stage, respectively.

Further, the cryocooler 14 includes a cryocooler structure part 21 that structurally supports the second cooling stage 24 on the first cooling stage 22 and structurally supports the first cooling stage 22 on a room temperature part 26 of the cryocooler 14. Therefore, the cryocooler structure part 21 includes a first cylinder 23 and a second cylinder 25 which coaxially extend along the radial direction of the cryopump 10. The first cylinder 23 connects a room temperature part 26 of the cryocooler 14 to the first cooling stage 22. The second cylinder 25 connects the first cooling stage 22 to the second cooling stage 24. Typically, the first cooling stage 22 and the second cooling stage 24 are formed of a high thermal conductivity metal material such as copper (for example, pure copper), and the first cylinder 23 and the second cylinder 25 are formed of other metal materials such as stainless steel. The room temperature part 26, the first cylinder 23, the first cooling stage 22, the second cylinder 25, and the second cooling stage 24 are linearly arranged in a row in this order.

A first displacer and a second displacer (not shown) are reciprocally disposed in the interiors of the first cylinder 23 and the second cylinder 25, respectively. A first regenerator and a second regenerator (not shown) are respectively incorporated into the first displacer and the second displacer. Further, the room temperature part 26 has a drive mechanism (not shown) for reciprocating the first displacer and the second displacer. The drive mechanism includes a flow path switching mechanism that switches a flow path for a working gas (for example, helium) to periodically repeat the supply and discharge of the working gas to and from interior of the cryocooler 14.

The cryocooler 14 is connected to a compressor (not shown) for the working gas. The cryocooler 14 cools the first cooling stage 22 and the second cooling stage 24 by expanding the working gas pressurized by the compressor in the interior thereof. The expanded working gas is recovered to the compressor and pressurized again. The cryocooler 14 generates cold by repeating a heat cycle including the supply and discharge of the working gas and the reciprocation of the first displacer and the second displacer in synchronization with the supply and discharge of the working gas.

The cryopump 10 which is shown in the drawing is a so-called horizontal cryopump. The horizontal cryopump is generally a cryopump in which the cryocooler 14 is disposed to intersect (usually, be orthogonal to) the center axis C of the cryopump 10. The present invention can similarly be applied to a so-called vertical cryopump. The vertical cryopump is a cryopump in which a cryocooler is disposed along the axial direction of the cryopump.

The cryopump container 16 is a vacuum chamber configured to maintain a vacuum airtightness of an internal space thereof. The cryocooler 14, the first-stage cryopanel 18, and the cryopanel unit 20 are accommodated in the cryopump container 16.

The cryopump intake port 12 is defined by a front end of the cryopump container 16. The cryopump container 16 includes an intake port flange 16a that extends outward in the radial direction from the front end thereof. The intake port flange 16a is provided over the entire circumference of the cryopump container 16. The cryopump 10 is mounted on the vacuum chamber 100 of the vacuum process equipment by using the intake port flange 16a. The cryopump 10 may be mounted on the vacuum chamber 100 via a gate valve (not shown).

In addition, the cryopump container 16 includes a container body portion 16b extending in the axial direction from the intake port flange 16a, a container bottom portion 16c that closes the container body portion 16b on the side opposite to the cryopump intake port 12, and a cryocooler accommodation cylinder 16d extending laterally between the intake port flange 16a and the container bottom portion 16c. The end portion of the cryocooler accommodation cylinder 16d on the side opposite to the container body portion 16b is mounted on the room temperature part 26 of the cryocooler 14, and thereby, the low-temperature section (that is, the first cylinder 23, the first cooling stage 22, the second cylinder 25, and the second cooling stage 24) of the cryocooler 14 is disposed in the cryopump container 16 in a non-contact manner with the cryopump container 16. The first cylinder 23 is disposed inside the cryocooler accommodation cylinder 16d, and the first cooling stage 22, the second cylinder 25, and the second cooling stage 24 are disposed inside the container body portion 16b. The first-stage cryopanel 18 and the cryopanel unit 20 are also disposed in the container body portion 16b.

The first-stage cryopanel 18 includes a radiation shield 30, an intake port plate 32, and a skirt 33, and surrounds the cryopanel unit 20. The first-stage cryopanel 18 provides a cryogenic surface for protecting the cryopanel unit 20 from the radiant heat from the outside of the cryopump 10 or the cryopump container 16. The first-stage cryopanel 18 is thermally coupled to the first cooling stage 22. Accordingly, the first-stage cryopanel 18 is cooled to the first cooling temperature. Therefore, a gas (for example, moisture) that is condensed at the first cooling temperature is captured on the surface. The first-stage cryopanel 18 is generally formed of a high thermal conductivity metal material such as copper (for example, pure copper), and the surface thereof may be coated with a metal layer such as nickel in a case of being necessary.

The first-stage cryopanel 18 has a gap between the first-stage cryopanel 18 and the cryopanel unit 20, and the first-stage cryopanel 18 is not in contact with the cryopanel unit 20. The first-stage cryopanel 18 is also not in contact with the cryopump container 16.

The radiation shield 30 is provided to protect the cryopanel unit 20 from the radiant heat of the cryopump container 16. The radiation shield 30 extends in a tubular shape (for example, a cylindrical shape) in the axial direction from the cryopump intake port 12 into the cryopump container 16. The radiation shield 30 is disposed between the cryopump container 16 and the cryopanel unit 20, and surrounds the cryopanel unit 20. The radiation shield 30 has a diameter slightly smaller than that of the cryopump container 16, and a shield outer gap 31 is formed between the radiation shield 30 and the cryopump container 16. Therefore, the radiation shield 30 is not in contact with the cryopump container 16.

The first cooling stage 22 of the cryocooler 14 is directly mounted on the side portion outer surface of the radiation shield 30. In this way, the radiation shield 30 is thermally coupled to the first cooling stage 22 to be cooled to the first cooling temperature. The radiation shield 30 may be mounted on the first cooling stage 22 via an appropriate heat transfer member. In addition, the second cooling stage 24 and the second cylinder 25 of the cryocooler 14 are inserted into the radiation shield 30 from the side portion of the radiation shield 30.

In the embodiment, the radiation shield 30 includes a shield upper portion 30a disposed close to the cryopump intake port 12 and a shield lower portion 30b disposed away from the cryopump intake port 12. The shield upper portion 30a is disposed on the cryopump intake port 12 side with respect to the second cooling stage 24 of the cryocooler 14, and the shield lower portion 30b is disposed on the container bottom portion 16c side with respect to the second cooling stage 24. The shield upper portion 30a is a cylinder in which both ends are open, and surrounds an upper portion of the cryopanel unit 20. The shield lower portion 30b is a bottomed cylinder in which an upper end thereof is open and a lower end is closed, and surrounds a lower portion of the cryopanel unit 20. The lower end of the shield upper portion 30a and the upper end of the shield lower portion 30b are located at substantially the same height. The diameter of the shield upper portion 30a is slightly smaller than the diameter of the shield lower portion 30b, and the shield outer gap 31 is made wider on the outer side of the shield upper portion 30a, compared to the outer side of the shield lower portion 30b.

The intake port plate 32 is provided in the cryopump intake port 12 in order to protect the cryopanel unit 20 from the radiant heat from a heat source outside the cryopump 10 (for example, a heat source in the vacuum chamber 100 on which the cryopump 10 is mounted). The intake port plate 32 is thermally coupled to the first cooling stage 22 via the radiation shield 30, and is cooled to the first cooling temperature, similarly to the radiation shield 30.

The intake port plate 32 extends along a plane perpendicular to the axial direction in the cryopump intake port 12. The intake port plate 32 is, for example, a single disk disposed perpendicular to the center axis C to cross the cryopump intake port 12, and the center thereof is located on or in the vicinity of the center axis C of the cryopump 10. The diameter of the intake port plate 32 is smaller than the diameter of the shield upper portion 30a, and as will be described later, a gap is formed between the intake port plate 32 and the shield upper portion 30a. In this example, the entire surface of the intake port plate 32 is flat and does not have an inclined surface.

In the shown example, the intake port plate 32 is disposed at the front end of the cryopump container 16 in the axial direction, that is, at the same height as the intake port flange 16a (for example, between the upper surface and the lower surface of the intake port flange 16a). The intake port plate 32 may be disposed on the upper side in the axial direction, that is, on the vacuum chamber 100 side, with respect to the front end of the cryopump container 16, or may be disposed on the lower side in the axial direction, that is, on the cryopanel unit 20 side, with respect to the front end of the cryopump container 16.

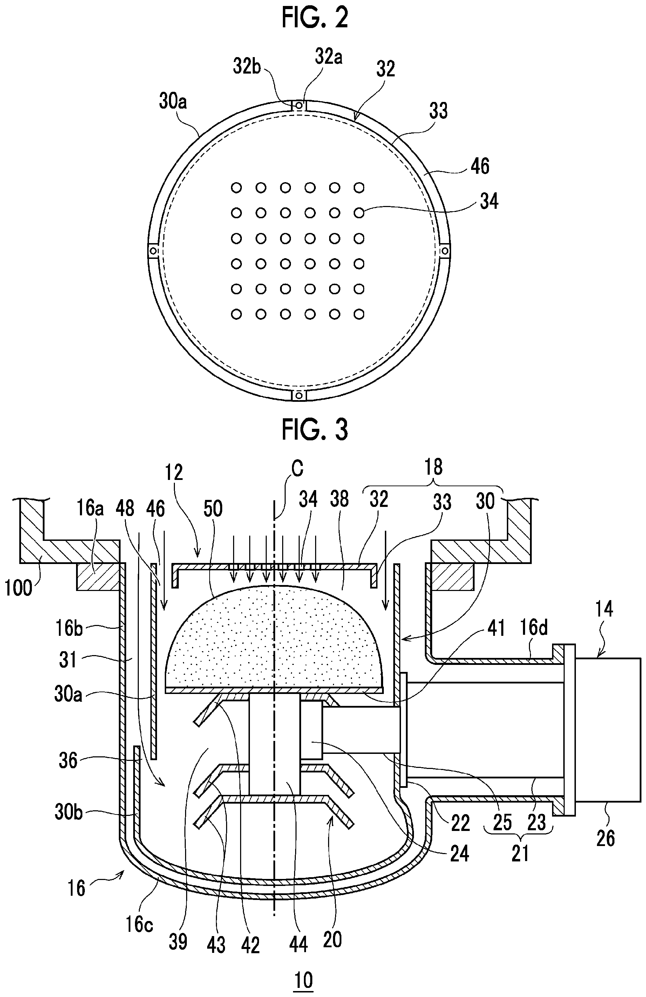

The intake port plate 32 is joined to an upper end of the shield upper portion 30a. For example, the intake port plate 32 may be mounted on a joint block (not shown) at the outer peripheral portion thereof. The joint block is a protrusion that protrudes inward in the radial direction at the upper end of the shield upper portion 30a, and the joint blocks are formed at equal intervals (for example, at 90° intervals) in the circumferential direction. As shown in Fig. 2, the outer periphery of the intake port plate 32 has a plate mounting portion 32a disposed to correspond to the joint block. The plate mounting portion 32a is fixed to the joint block by using a fastening member 32b such as a bolt or by using other appropriate methods such as welding.

The cryopanel unit 20 includes a plurality of cryopanels (41, 42, 43) arranged in the axial direction. Each of the cryopanels is thermally coupled to the second cooling stage 24 and is cooled to the second cooling temperature lower than the first cooling temperature. The cryopanel unit 20 is disposed inside the radiation shield 30 in the cryopump container 16 and below the intake port plate 32 in the axial direction.

For convenience of description, the cryopanel closest to the cryopump intake port 12 among the cryopanels will be referred to as a top cryopanel 41. Therefore, the top cryopanel 41 is disposed closest to the intake port plate 32 in the axial direction in the cryopanel unit 20. The front surface of the top cryopanel 41 faces the back surface of the intake port plate 32, and other cryopanels are not provided between the top cryopanel 41 and the intake port plate 32. The top cryopanel 41 is, for example, a disk-shaped member disposed perpendicular to the axial direction, and the center thereof is located on or in the vicinity of the center axis C of the cryopump 10. The top cryopanel 41 is flat over the entire surface and does not have an inclined surface.

In order to condense more gas, the top cryopanel 41 may be relatively large, and the diameter of the top cryopanel 41 may be, for example, 70% or more or 80% or more of the diameter of the radiation shield 30 (for example, the shield upper portion 30a). In addition, the diameter of the top cryopanel 41 may be 98% or less or 90% or less of the diameter of the radiation shield 30 (for example, the shield upper portion 30a). Accordingly, the top cryopanel 41 can be reliably brought into non-contact with the radiation shield 30.

The top cryopanel 41 may be disposed in the vicinity of substantially the middle in the axial direction in the container body portion 16b of the cryopump container 16. The center portion of the top cryopanel 41 may be directly mounted on the upper surface of the second cooling stage 24 of the cryocooler 14. The axial distance from the intake port plate 32 to the top cryopanel 41 may be in a range of, for example, 30% to 70% or 40% to 60% of the axial distance from the intake port plate 32 to the container bottom portion 16c. In this manner, a relatively wide free space is formed between the cryopanel unit 20 (that is, the top cryopanel 41) and the intake port plate 32 in the axial direction. This space can be used as a frost accommodation space 38 for accommodating a condensed layer of an exhausted gas that condenses on the top cryopanel 41.

In addition to the top cryopanel 41, one or a plurality of intermediate cryopanels 42, one or a plurality of lower cryopanels 43, and a connection cryopanel 44 are provided in the cryopanel unit 20. In this example, one intermediate cryopanel 42 and two lower cryopanels 43 are provided. The axial interval between the intermediate cryopanel 42 and the lower cryopanel 43 may be wider than the axial interval between the lower cryopanels 43, and thus, a relatively wide condensed layer accommodation space may be formed between the intermediate cryopanel 42 and the lower cryopanel 43. This space can be used as a frost accommodation space 39 for accommodating a condensed layer that condenses on the lower cryopanel 43.

As an example, the diameters of the intermediate cryopanel 42 and the lower cryopanel 43 may be smaller than the diameter of the top cryopanel 41. In addition, the diameter of the intermediate cryopanel 42 may be smaller than the diameter of the lower cryopanel 43.

In the shown example, each of the intermediate cryopanel 42 and the lower cryopanel 43 has a truncated conical shape, and has a flat disk-shaped center portion and a radially outer downward inclined outer peripheral portion. The centers of these cryopanels are located on or in the vicinity of the center axis C of the cryopump 10. In the axial direction, the intermediate cryopanel 42 is located below the top cryopanel 41 and above the second cooling stage 24, and the lower cryopanel 43 is located below the second cooling stage 24. For example, the intermediate cryopanel 42 may be sandwiched between the top cryopanel 41 and the second cooling stage 24. Alternatively, the intermediate cryopanel 42 may be located at the same height as the second cooling stage 24 (for example, between the upper surface and the lower surface of the second cooling stage 24).

The connection cryopanel 44 extends from the second cooling stage 24 to the lower cryopanel 43 and thermally couples the lower cryopanel 43 to the second cooling stage 24. The connection cryopanel 44 may be a set of elongated plate-shaped members extending in the axial direction on both sides in the radial direction of the second cooling stage 24. An upper end of the connection cryopanel 44 is mounted on the second cooling stage 24, and a lower end is mounted on the lower cryopanel 43.

Each of the cryopanels (41, 42, 43) configuring the cryopanel unit 20 is generally formed of a high thermal conductivity metal material such as copper (for example, pure copper), and the surface thereof may be coated with a metal layer such as nickel in a case of being necessary. In addition, an adsorbent (for example, activated carbon) that captures a non-condensable gas (for example, hydrogen) by adsorption may be provided on the surface of at least a part of the cryopanel unit 20. For example, the adsorbent may be provided on the back surface of the top cryopanel 41, the intermediate cryopanel 42, and/or the lower cryopanel 43.

In addition, the specific configuration of the cryopanel unit 20 is not limited to the configuration described above. For example, an additional cryopanel may be provided between the top cryopanel 41 and the intake port plate 32, and the additional cryopanel may have a smaller diameter than the top cryopanel 41. The top cryopanel 41 may have a radially outer downward (or upward) inclined surface at an outer peripheral portion thereof. At least one cryopanel (for example, the lowermost cryopanel) of the intermediate cryopanel 42 and the lower cryopanel 43 may have a larger diameter than the top cryopanel 41. The intermediate cryopanel 42 and/or the lower cryopanel 43 may be a disk-shaped plate without an inclined surface, as in the top cryopanel 41. The shape of the cryopanel when viewed in the axial direction is not limited to a circular shape, and may be other shapes such as a rectangular shape and a polygonal shape.

A first gas inlet 34 for introducing a gas from the outside to the inside of the cryopump 10 is formed in the first-stage cryopanel 18. The first gas inlet 34 is at least one opening portion formed in the intake port plate 32. The opening portion is a hole penetrating the intake port plate 32, and therefore, a gas flow from the vacuum chamber 100 to the frost accommodation space 38 through the first gas inlet 34 is allowed.

At least one opening portion of the intake port plate 32 serving as the first gas inlet 34 is formed in the center portion of the intake port plate 32. The center portion of the intake port plate 32 may be in a range of, for example, 3/4 or less, 1/2 or less, or 1/4 or less of the diameter of the cryopump intake port 12. The opening portion as the first gas inlet 34 is not formed in the outer peripheral portion of the intake port plate 32 outside the center portion of the intake port plate 32.

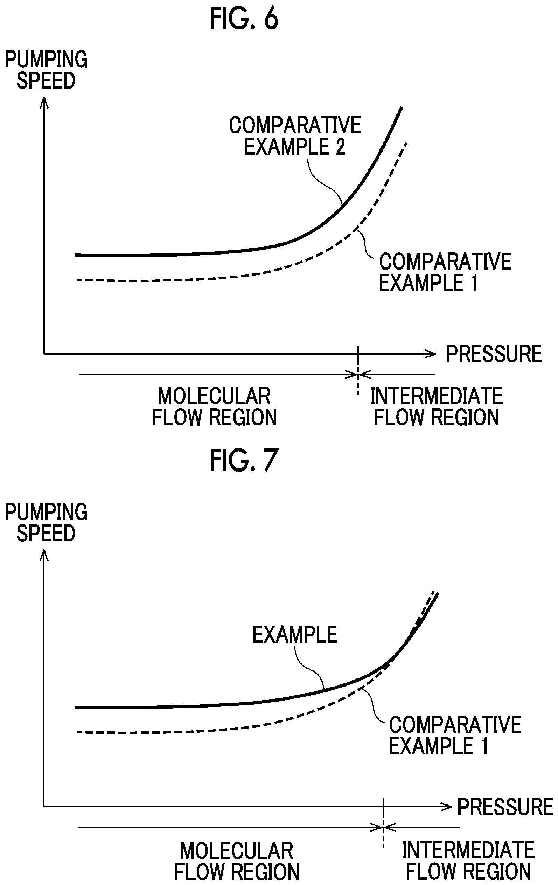

As shown in the drawings, a large number of opening portions may be formed in the intake port plate 32. As an example, in Fig. 2, 6 x 6 = 36 pieces of opening portions are shown. The opening portions may be regularly arranged on the intake port plate 32, for example, in a lattice shape as shown in the drawing. The opening portions may be provided at equal intervals in each of the radial direction and the circumferential direction. The shape of the opening portion is, for example, a circular shape, but is not limited thereto, and may be other shapes such as a rectangular shape and an oblong shape.

In addition, a second gas inlet 36 for introducing a gas from the outside to the inside of the cryopump 10 is also formed in the first-stage cryopanel 18. The second gas inlet 36 is a gap (referred to as a shield gap in the present specification) between the shield upper portion 30a and the shield lower portion 30b in the radiation shield 30 having a divided structure as described above.

An axial distance from the intake port plate 32 to the shield gap is larger than an axial distance from the intake port plate 32 to the top cryopanel 41. The second gas inlet 36 is located on the lower side in the axial direction with respect to the top cryopanel 41, that is, is formed at an axial height between the top cryopanel 41 and the container bottom portion 16c. In this example, the second gas inlet 36 is formed at an axial height between the intermediate cryopanel 42 and the lower cryopanel 43. The second gas inlet 36 may be formed between the top cryopanel 41 and the intermediate cryopanel 42. Therefore, a gas flow from the vacuum chamber 100 to the frost accommodation space 39 below the top cryopanel 41 through the shield outer gap 31 and the second gas inlet 36 is allowed.

The shield gap between the shield upper portion 30a and the shield lower portion 30b may be set at any position in the axial direction, or may be provided at an axial height between the top cryopanel 41 and the intake port plate 32. In this case, a gas flow from the vacuum chamber 100 to the frost accommodation space 38 above the top cryopanel 41 through the second gas inlet 36 is allowed.

In the embodiment, the skirt 33 is provided at the intake port plate 32. The skirt 33 extends from the outer periphery of the intake port plate 32 into the radiation shield 30. The skirt 33 extends in the axial direction, that is, parallel to the radiation shield 30.

An axial length L of the skirt 33 is smaller than an axial distance from the intake port plate 32 to the top cryopanel 41. For example, the axial length L of the skirt 33 may be smaller than 3/4, 1/2, or 1/4 of the axial distance from the intake port plate 32 to the top cryopanel 41. In this manner, the skirt 33 is disposed relatively above the frost accommodation space 38 together with the intake port plate 32. The skirt 33 is not in physical contact with the cryopanel unit 20 such as the top cryopanel 41, similarly to the radiation shield 30 and the intake port plate 32.

The second gas inlet 36 is provided on the lower side in the axial direction with respect to the top cryopanel 41, as described above, and therefore, the axial length L of the skirt 33 becomes smaller than the axial distance from the intake port plate 32 to the second gas inlet 36. This is helpful to increase the diameter of the top cryopanel 41 and ultimately increase the gas storage capacity of the cryopump 10. In a case where the skirt 33 extends to a position below the top cryopanel 41 in the axial direction, the top cryopanel 41 is surrounded by the skirt 33. In order to prevent the top cryopanel 41 and the skirt 33 from coming into physical contact with each other, the diameter of the top cryopanel 41 needs to be smaller than the diameter of the skirt 33. It is desirable to avoid the downsizing of the top cryopanel 41 because the downsizing causes a decrease in the gas storage capacity of the cryopump 10.

The skirt 33 is a ring or a short cylinder that borders the intake port plate 32, and can be said to form a so-called circular tray together with the intake port plate 32. The intake port plate 32 with the skirt 33 is disposed in the cryopump intake port 12 to cover most of the open area on the inner side of the upper end of the radiation shield 30. In Fig. 2, the skirt 33 is shown by a broken line for understanding.

The diameters of the intake port plate 32 and the skirt 33 are smaller than the inner diameter of the radiation shield 30 (for example, the shield upper portion 30a). However, the diameters of the intake port plate 32 and the skirt 33 may be, for example, 70% or more, 80% or more, or 90% or more of the inner diameter of the radiation shield 30 (for example, the shield upper portion 30a) such that the intake port plate 32 can occupy most of the open area on the inner side of the upper end of the radiation shield 30.

Therefore, as shown in Figs. 1 and 2, in addition to the first gas inlet 34 and the second gas inlet 36, a gas inlet 46 serving as an additional gas inlet is formed between the intake port plate 32 and the radiation shield 30 (more specifically, an upper end of the shield upper portion 30a). The gas inlet 46 is a radial gap between the radiation shield 30 and the intake port plate 32. Further, a gas flow path 48 is formed between the skirt 33 and the radiation shield 30. The gas flow path 48 is a radial gap between the radiation shield 30 and the skirt 33. The gas inlet 46 is connected to the frost accommodation space 38 above the top cryopanel 41 through the gas flow path 48. Therefore, a gas flow from the vacuum chamber 100 to the frost accommodation space 38 through the gas inlet 46 and the gas flow path 48 is allowed.

In this way, the cryopump 10 has three paths in order to guide the gas to be exhausted from the vacuum chamber 100 to the cryopanel unit 20 in the cryopump 10. The first path is a path from the first gas inlet 34 to the frost accommodation space 38. The second path reaches the frost accommodation space 39 via the second gas inlet 36 from the shield outer gap 31. The third path reaches the frost accommodation space 38 via the gas flow path 48 from the gas inlet 46. These three paths contribute to improving the pumping speed of the cryopump 10.

In the shown example, the shield outer gap 31 is wider than the gas flow path 48. That is, as shown in Fig. 1, a radial distance R1 from the radiation shield 30 to the cryopump container 16 in the cryopump intake port 12 is larger than a radial distance R2 from the skirt 33 to the radiation shield 30 in the gas flow path 48. It has been confirmed by verification of the inventor of the present invention that such a dimension setting between the shield outer gap 31 and the gas flow path 48 is effective in shortening the recovery time of the cryopump 10.

The axial length L of the skirt 33 may be within 8 times the radial distance R2 from the skirt 33 to the radiation shield 30. In this way, it has been confirmed by verification of the inventor of the present invention that the recovery time of the cryopump 10 can be effectively shortened.

In addition, as shown in the drawings, the diameter of the skirt 33 may be smaller than the diameter of the top cryopanel 41. Since the skirt 33 has the same diameter as the intake port plate 32, the diameter of the intake port plate 32 may also be smaller than the diameter of the top cryopanel 41. In this way, the gas inlet 46 and the gas flow path 48 can be relatively widened. This is helpful to increase the opening ratio of the cryopump intake port 12 and to increase the pumping speed of the cryopump 10. In addition, since the area of the top cryopanel 41 can be made relatively large, the gas storage capacity of the cryopump 10 can be increased.

The operation of the cryopump 10 having the above configuration will be described below. Fig. 3 is a schematic diagram showing the cryopump 10 during an evacuation operation according to the embodiment. When the cryopump 10 operates, first, the inside of the vacuum chamber 100 is roughly pumped to, for example, a cryopump operation start pressure of about 1 Pa by another suitable roughing pump (not shown) before the operation. Thereafter, the cryopump 10 is operated. The first cooling stage 22 and the second cooling stage 24 are respectively cooled to the first cooling temperature and the second cooling temperature by driving of the cryocooler 14. Therefore, the first-stage cryopanel 18 and the cryopanel unit 20 thermally coupled to these cooling stages are also cooled to the first cooling temperature and the second cooling temperature, respectively.

The intake port plate 32 cools a gas that comes flying from the vacuum chamber 100 toward the cryopump 10. A gas having a sufficiently low vapor pressure (for example, 10⁻⁸ Pa or less) at the first cooling temperature condenses on the surface of the intake port plate 32. This gas may be referred to as a type 1 gas. The type 1 gas is, for example, water vapor. In this way, the intake port plate 32 can exhaust the type 1 gas.

As shown by a solid line arrow in Fig. 3, a part of the gas enters the cryopump 10 from any one of the three paths described above. That is, the gas can enter the frost accommodation space 38 through the first gas inlet 34 from the vacuum chamber 100. In addition, the gas can enter the gas inlet 46 from the vacuum chamber 100 and further enter the frost accommodation space 38 through the gas flow path 48. Further, the gas can enter the shield outer gap 31 from the vacuum chamber 100 and further enter the frost accommodation space 39 through the second gas inlet 36. In this case, since the radiation shield 30 and the skirt 33 are also cooled to the first cooling temperature, the type 1 gas can condense on the surfaces thereof to be exhausted. A gas having a vapor pressure that is not sufficiently low at the first cooling temperature can enter the inside of the radiation shield 30 through these paths.

The gas that has entered from the first gas inlet 34 and the gas inlet 46 is cooled by the top cryopanel 41. The gas that has entered from the second gas inlet 36 is cooled by the intermediate cryopanel 42 or the lower cryopanel 43. A gas having a sufficiently low vapor pressure (for example, 10⁻⁸ Pa or lower) at the second cooling temperature condenses on the surfaces of these cryopanels. This gas may be referred to as a type 2 gas. The type 2 gas is, for example, argon (Ar). In this way, the cryopanel unit 20 can exhaust the type 2 gas.

For understanding, in Fig. 3, a condensed layer 50 of the gas condensed on the top cryopanel 41 is shown. As shown in the drawing, the condensed layer 50 can form a hemispherical ice mass in the frost accommodation space 38. In Fig. 3, for convenience, for example, the other condensed layer such as a condensed layer on the lower cryopanel 43 is not shown.

In the embodiment, the skirt 33 is disposed above the frost accommodation space 38 in the axial direction together with the intake port plate 32. For example, the axial length L of the skirt 33 may be smaller than, for example, 1/2 of the axial distance from the intake port plate 32 to the top cryopanel 41, as described above. In this way, a relatively large axial gap is formed between the skirt 33 and the top cryopanel 41, and a larger condensed layer 50 can condense on the top cryopanel 41. The gas storage capacity of the cryopump 10 can be increased.

In addition, since the first gas inlet 34 is formed in the center portion of the intake port plate 32, the condensed layer 50 can be evenly grown on the top cryopanel 41 together with the gas inlet 46 formed around the intake port plate 32.

A gas having a vapor pressure which is not sufficiently low at the second cooling temperature is adsorbed by an adsorbent on the cryopanel unit 20. This gas may be referred to as a type 3 gas. The type 3 gas is, for example, hydrogen (H₂). In this way, the cryopanel unit 20 can exhaust the type 3 gas. Therefore, the cryopump 10 can exhaust various gases by condensation or adsorption and make the degree of vacuum of the vacuum chamber 100 reach a desired level.

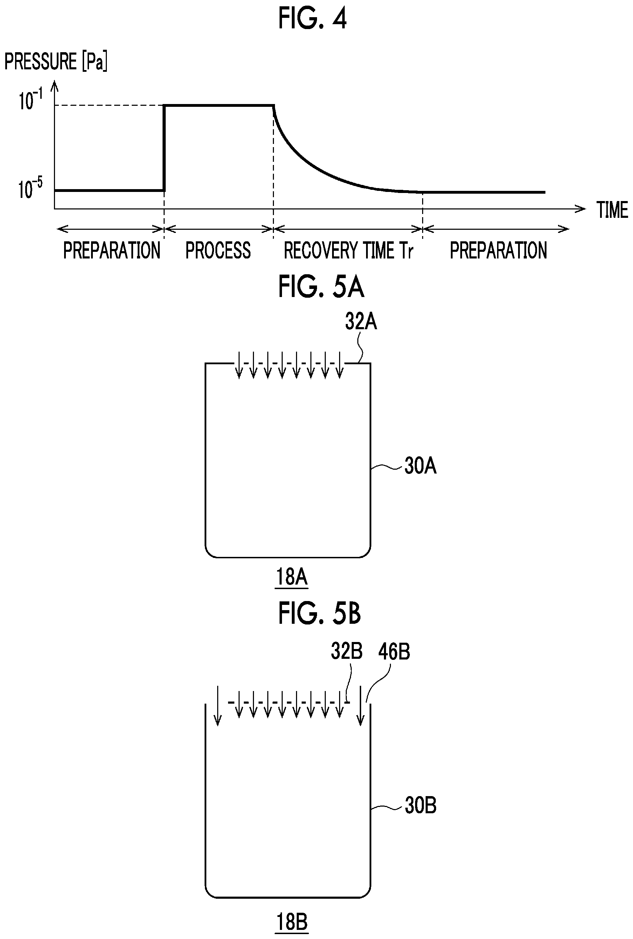

Fig. 4 is a diagram schematically showing an exemplary pressure change during the operation of vacuum process equipment (for example, a PVD apparatus) equipped with the cryopump 10 according to the embodiment. In Fig. 4, how the pressure in the vacuum chamber of the equipment fluctuates during a vacuum process (for example, a PVD process) in the vacuum process equipment and during an interval between the processes is schematically shown.

A process gas is supplied to the vacuum chamber during the process. The pressure in the vacuum chamber is maintained at the degree of vacuum suitable for the vacuum process by a balance between the supply of the process gas to the vacuum chamber and the evacuation of the vacuum chamber by the cryopump. The degree of vacuum during the process may be an intermediate flow region of an order of 10⁻¹ Pa, for example. Since the supply of the process gas is stopped in the interval between the processes, the degree of vacuum of the vacuum chamber is recovered to a desired degree of vacuum higher than that during the process by the cryopump. In the interval, for example, the degree of vacuum is recovered to a molecular flow region of an order of 10⁻⁵ Pa to 10⁻⁶ Pa. In the interval, preparation for the process is performed in which a processed substrate such as a semiconductor wafer, for example, is unloaded from the vacuum chamber and a new substrate is loaded into the vacuum chamber.

As described at the beginning of the present specification, a time required for the recovery of the degree of vacuum in the interval between the processes is also referred to as a recovery time (or a return time). In Fig. 4, the recovery time is indicated by a reference symbol Tr. The shorter the recovery time Tr, the earlier the next process can be started, and the productivity of the vacuum process equipment is improved.

Therefore, it is desirable that the recovery time Tr is as short as possible. In order to shorten the recovery time Tr, the pumping speed of the cryopump may be increased. As one means for that, it is generally recognized to increase an opening ratio of a cryopump intake port, that is, the ratio of an opening area to the total area of the intake port.

Figs. 5A and 5B are schematic diagrams showing first-stage cryopanels of cryopumps according to comparative examples. In Comparative Example 1 shown in Fig. 5A, a first-stage cryopanel 18A has a radiation shield 30A and an intake port shield 32A that blocks an opening portion of the radiation shield 30A. However, the intake port shield 32A is formed with a large number of small holes for introducing a gas into the radiation shield 30A. Comparative Example 1 is a typical example of a first-stage cryopanel in an existing cryopump.

In Comparative Example 2 shown in Fig. 5B, a first-stage cryopanel 18B has a radiation shield 30B and an intake port shield 32B disposed at the center portion of the opening portion of the radiation shield 30B. The intake port shield 32B is formed with a large number of small holes for introducing a gas into the radiation shield 30B. Since the intake port shield 32B is disposed at the center portion of the opening portion of the radiation shield 30B, a gap 46B is formed between the intake port shield 32B and the radiation shield 30B. In this manner, in Comparative Example 2 shown in Fig. 5B, the opening ratio of the cryopump intake port is higher than that in Comparative Example 1 shown in Fig. 5A. Not only the small holes of the intake port shield 32B but also the gap can be used to introduce the gas into the radiation shield 30A. Comparative Example 2 is based on the consideration of the inventor of the present invention, and is an example of a first-stage cryopanel that can realize a higher pumping speed than that in Comparative Example 1.

Fig. 6 is a schematic diagram showing the pumping speeds of the cryopumps according to the comparative examples of Figs. 5A and 5B. In Fig. 6, a change in the pumping speed with respect to the pressure (the degree of vacuum) from the intermediate flow region to the molecular flow region is shown for Comparative Example 1 shown in Fig. 5A and Comparative Example 2 shown in Fig. 5B. As shown in Fig. 6, in general, in the intermediate flow region, the pumping speed of the cryopump increases as the pressure is higher. In contrast, in the molecular flow region, the pumping speed is substantially constant regardless of the pressure. This is because the pumping speed of the cryopump in the molecular flow region is determined from the opening area of the cryopump intake port. When the pumping speeds are compared between Comparative Example 1 and Comparative Example 2, as described above, the opening ratio of the cryopump intake port in Comparative Example 2 is higher than that in Comparative Example 1, and therefore, the pumping speed in Comparative Example 2 is higher than that in Comparative Example 1 from the intermediate flow region to the molecular flow region.

Therefore, when the cryopumps according to these comparative examples are applied to the vacuum process equipment, the cryopump of Comparative Example 2 can provide a higher pumping speed than that of Comparative Example 1 in both during the process and the interval between the processes. The high pumping speed at the interval may shorten the recovery time and improve the throughput of the vacuum process equipment.

However, an increase in the pumping speed during the process may reduce the vacuum chamber pressure during the process. In some cases, the vacuum chamber pressure may deviate from a desired default pressure for the process. Such an unintended change in the process recipe may have an unexpected influence on the quality of the process. For example, in the vacuum film-formation, the pressure during the process affects a film thickness that is generated. In other words, it is concerned that an increase in the opening ratio of the cryopump intake port may bring about a disadvantage of inconsistency with an existing vacuum process, while leading to an advantage of shortening the recovery time and improving the productivity of the vacuum process equipment due to the shortening of the recovery time.

Therefore, in the embodiment, in addition to the gas inlet 46 around the intake port plate 32, the skirt 33 is provided in the intake port plate 32, and the gas flow path 48 connecting the gas inlet 46 to the frost accommodation space 38 is formed between the skirt 33 and the radiation shield 30. The skirt 33 allows the conductance of the cryopump intake port 12 to be adjusted to be different between the intermediate flow region and the molecular flow region.

In the intermediate flow region, the gas takes a behavior closer to a viscous flow than in the molecular flow region, and therefore, the skirt 33 lowers the conductance of the cryopump intake port 12, compared to a case where the skirt 33 is not provided in the intake port plate 32. The longer the axial length L of the skirt 33, the smaller the conductance becomes.

Therefore, in the intermediate flow region, the skirt 33 can cancel an increase in conductance that is obtained by an increase in the opening ratio of the cryopump intake port 12 by the gas inlet 46. That is, the conductance of the cryopump intake port 12 having both the gas inlet 46 and the skirt 33 can be maintained to be the same as that in a case where these are not provided in the cryopump intake port 12 (for example, Comparative Example 1).

On the other hand, in the molecular flow region, the conductance of the cryopump intake port 12 is determined according to the opening area of the cryopump intake port 12. Since the skirt 33 extends parallel to the radiation shield 30, the skirt 33 does not substantially affect the flow path cross-sectional area of the gas flow path 48. A decrease in conductance due to the skirt 33 in the molecular flow region is smaller than a decrease in conductance due to the skirt 33 in the intermediate flow region. That is, the influence of the skirt 33 in the molecular flow region is small.

Therefore, in the molecular flow region, even though the skirt 33 is provided in the intake port plate 32, the conductance of the cryopump intake port 12 increases due to the effect of an increase in the opening ratio of the cryopump intake port 12 by the gas inlet 46. That is, the conductance of the cryopump intake port 12 having both the gas inlet 46 and the skirt 33 is increased compared to a case where these are not provided in the cryopump intake port 12 (for example, Comparative Example 1).

Fig. 7 is a schematic diagram showing the pumping speed of the cryopump 10 according to the embodiment. In Fig. 7 as well, similarly to Fig. 6, a change in the pumping speed with respect to the pressure (the degree of vacuum) from the intermediate flow region to the molecular flow region is shown. In Fig. 7, the pumping speed of Comparative Example 1 described above is shown by a broken line, and the pumping speed of the cryopump 10 according to the embodiment is shown by a solid line.

The conductance of the cryopump intake port 12 is a main factor that determines the pumping speed of the cryopump 10. Therefore, the cryopump 10 according to the embodiment can increase the pumping speed in the molecular flow region, compared to an existing cryopump as in Comparative Example 1. That is, the cryopump 10 can provide a higher pumping speed than in Comparative Example 1 in the interval between the processes in the vacuum process equipment. In addition, the cryopump 10 according to the embodiment can match the pumping speed with that of an existing cryopump as in Comparative Example 1 in the intermediate flow region.

Therefore, according to the embodiment, it is possible to provide the cryopump 10 that enables both the improvement in productivity of the vacuum process equipment through the shortening of the recovery time and the compatibility with an existing vacuum process in the vacuum process equipment.

The present invention has been described above based on the examples. It will be understood by those skilled in the art that the present invention is not limited to the above embodiments, various design changes can be made, various modification examples are possible, and such modification examples are also within the scope of the present invention. Various features described in relation to a certain embodiment are also applicable to other embodiments. New embodiments resulting from combinations have the effect of each of embodiments which are combined.

In the embodiment described above, the intake port plate 32 has at least one opening portion as the first gas inlet 34 in the center portion thereof. Along with this, or instead of this, the first gas inlet 34 may be formed in the outer peripheral portion of the intake port plate 32. In addition, in a certain embodiment, the intake port plate 32 may not have the opening portion as the first gas inlet 34.

In the embodiment described above, the radiation shield 30 includes a plurality of divided portions, and has the shield upper portion 30a and the shield lower portion 30b. Alternatively, the radiation shield 30 may be a single component that extends from the cryopump intake port 12 to the container bottom portion 16c. The second gas inlet 36 may be at least one opening portion formed in such a single component.

In the embodiment described above, the skirt 33 extends parallel to the radiation shield 30. Alternatively, in a certain embodiment, the skirt 33 may extend radially outward (or radially inward) and obliquely downward from the outer periphery of the intake port plate 32.

The present invention has been described above based on the examples. It will be understood by those skilled in the art that the present invention is not limited to the above embodiments, various design changes can be made, various modification examples are possible, and such modification examples are also within the scope of the present invention.

### Brief Description of the Reference Symbols

10: cryopump
12: cryopump intake port
14: cryocooler
16: cryopump container
20: cryopanel unit
22: first cooling stage
24: second cooling stage
30: radiation shield
30a: shield upper portion
30b: shield lower portion
32: intake port plate
33: skirt
41: top cryopanel
46: gas inlet
48: gas flow path

## Claims

1. A cryopump (10) comprising:
a cryopump container (16) that defines a cryopump intake port (12);
a cryocooler (14) that is installed in the cryopump container (16) and includes a first cooling stage (22) and a second cooling stage (24) that is cooled to a lower temperature than the first cooling stage (22);
a radiation shield (30) that is thermally coupled to the first cooling stage (22) and extends in an axial direction from the cryopump intake port (12) into the cryopump container (16);
an intake port plate (32) that is thermally coupled to the first cooling stage (22) and extends along a plane perpendicular to the axial direction in the cryopump intake port (12), and in which a gas inlet (46) is formed between the intake port plate (32) and the radiation shield (30);
a cryopanel unit (20) that is thermally coupled to the second cooling stage (24) and is disposed inside the radiation shield (30), and in which a frost accommodation space (38) is formed between the cryopanel unit (20) and the intake port plate (32); and
a skirt (33) that is thermally coupled to the first cooling stage (22) and extends from an outer periphery of the intake port plate (32) into the radiation shield (30), and in which a gas flow path (48) connecting the gas inlet (46) to the frost accommodation space (38) is formed between the skirt (33) and the radiation shield (30).

2. The cryopump (10) according to claim 1, wherein the cryopanel unit (20) includes a top cryopanel (41) disposed closest to the intake port plate (32) in the axial direction in the cryopanel unit (20), and
an axial length (L) of the skirt (33) is smaller than an axial distance from the intake port plate (32) to the top cryopanel (41).

3. The cryopump (10) according to claim 2, wherein the axial length (L) of the skirt (33) is smaller than 1/2 of the axial distance from the intake port plate (32) to the top cryopanel (41).

4. The cryopump (10) according to claim 2, wherein a diameter of the skirt (33) is smaller than a diameter of the top cryopanel (41).

5. The cryopump (10) according to claim 1, wherein the skirt (33) extends parallel to the radiation shield (30).

6. The cryopump (10) according to claim 1, wherein a radial distance from the radiation shield (30) to the cryopump container (16) in the cryopump intake port (12) is larger than a radial distance from the skirt (33) to the radiation shield (30) in the gas flow path (48).

7. The cryopump (10) according to claim 1, wherein the radiation shield (30) includes a shield upper portion (30a) disposed close to the cryopump intake port (12), and a shield lower portion (30b) disposed away from the cryopump intake port (12), and the shield upper portion (30a) and the shield lower portion (30b) are disposed with a shield gap (36) therebetween, and
an axial length (L) of the skirt (33) is smaller than an axial distance from the intake port plate (32) to the shield gap (36).

8. The cryopump (10) according to claim 7, wherein the cryopanel unit (20) includes a top cryopanel (41) disposed closest to the intake port plate (32) in the cryopanel unit (20), and
the axial distance from the intake port plate (32) to the shield gap (36) is larger than an axial distance from the intake port plate (32) to the top cryopanel (41).

9. The cryopump (10) according to claim 1, wherein the intake port plate (32) has at least one opening portion (34) .

10. The cryopump (10) according to claim 9, wherein the at least one opening portion (34) is formed in a center portion of the intake port plate (32).
